Europäisches Patentamt

European Patent Office

Office européen des brevets

(11) Veröffentlichungsnummer: **0 111 644**
A2

(12) # EUROPÄISCHE PATENTANMELDUNG

(21) Anmeldenummer: 83109336.4

(22) Anmeldetag: 20.09.83

(51) Int. Cl.³: **H 01 L 21/48**
H 01 L 23/14

(30) Priorität: 27.09.82 DE 3235702

(43) Veröffentlichungstag der Anmeldung:
27.06.84 Patentblatt 84/26

(84) Benannte Vertragsstaaten:
AT DE FR GB IT NL

(71) Anmelder: SIEMENS AKTIENGESELLSCHAFT
Berlin und München Wittelsbacherplatz 2
D-8000 München 2(DE)

(72) Erfinder: Koch, Dirk
Leharstrasse 9 A
D-8900 Augsburg 21(DE)

(54) Verfahren zur Herstellung von Halbleiterchips-Filmträgern.

(57) Die Erfindung bezieht sich auf ein Verfahren zur Herstellung von Halbleiterchip-Filmträgern, die auf der einen Seite mit einer Kupferkaschierung versehen und im Kunststoffträgerbereich eine Aussparung für Halbleiterbauelemente enthalten. Bei derartigen Filmträgern muß zur Vermeidung von Metallabscheidungen auf der der Struktur abgewandten Seite das Folienband auf der Oberfläche einer entsprechenden Entwicklerlösung schwimmend von unten entwickelt werden. Auch alle übrigen Verfahrensschritte können nur einseitig vorgenommen werden, was zu einer erheblichen Verfahrenserschwernis führt. Zur Vereinfachung sieht die Erfindung vor, je zwei Filme über ein Bindemittel zu einem Laminat zusammenzuführen, dann zu entwickeln und anschließend beide Filme wieder zu trennen.

EP 0 111 644 A2

./...

FIG 1

SIEMENS AKTIENGESELLSCHAFT      Unser Zeichen
Berlin und München              VPA  82 P 1 8 6 2 E

Verfahren zur Herstellung von Halbleiterchips-Filmträgern

Die Erfindung betrifft ein Verfahren zur Herstellung von Halbleiterchips-Filmträgern, die aus einem auf der einen Seite mit einer eine Fotolackschicht tragenden Kupferkaschierung versehenen Kunststoffträger bestehen, bei dem auf der von der Kupferkaschierung abgewandten Seite im Bereich des jeweiligen Halbleitereinbauplatzes eine Aussparung bis zur Kupferschicht vorgesehen ist und bei dem die Leiterstruktur durch ein Fotoätzverfahren erzeugt ist.

Bei der Herstellung von "Filmen" als Träger für Halbleiterchips wird z. B. ein einseitig mit Cu-kaschierter Kunststoffträger mit Hilfe von photolitografischen Prozessen derart vorbereitet, daß die zur Strukturerzeugung freientwickelten Bereiche anschließend einseitig galvanisiert und geätzt werden können. Weil bei diesem Prozeß im Bereich des Halbleitereinbauplatzes der Kunststoffträger von der metallabgewandten Seite mit einer entsprechenden Aussparung versehen ist, besteht die Notwendigkeit, das von dieser Seite ungeschütze Kupfer gegenüber der galvanischen Abscheidung bzw. dem nachfolgenden Ätzprozeß abzudecken. Im Rahmen des bisher hierfür eingesetzten Prozesses wird eine doppelseitige Fotolackbeschichtung durch eine Tauchbeschichtung im Durchlaufverfahren vorgenommen. Bei der nachfolgenden Belichtung wird in die auf der Cu-Seite befindlichen Lackschicht die entsprechende Struktur belichtet  Zur Vermeidung von Metallabscheidungen auf der der Struktur abgewandten Seite wird das Folienband auf der Oberfläche einer entsprechenden Entwicklerlösung schwimmend von unten entwickelt. Hiernach wird das Folienband nach einer Vorreinigung mit einer galvanisch abge-

Zk 1 Fdl/ 3. 8. 1982

schiedenen Metallschicht im Banddurchlaufverfahren versehen. Vor dem nachfolgenden Ätzschritt darf das Folienband wiederum nur einseitig entschichtet werden, damit der rückwärtige Lackschutz des Kupfers bestehen bleibt.

Während des Ätzens mit dem selektiven Ätzmittel dient die galvanisch erzeugte Schicht an dieser Stelle als Ätzreserve. Nach dem Ätzen wird das Folienband vollständig entschichtet, gereinigt und getrocknet. Der Film ist fertiggestellt und wird nun noch einer entsprechenden Endprüfung unterzogen.

Aufgabe der vorliegenden Erfindung ist es, den Bearbeitungsprozess bei einem Verfahren zur Herstellung von Filmträgern für Halbleiterchips mit Aussparungen für die Halbleiterbauteile zu vereinfachen.

Zur Lösung dieser Aufgabe wird gemäß der Erfindung derart verfahren, daß zwei Filmträger kunstoffolienseitig über eine klebende Zwischenlage deckungsgleich vor dem Bearbeitungsprozess zusammengeklebt und nach dem Bearbeitungsprozess während des Entschichtungsvorgangs wieder getrennt werden.

Durch das dichte Zusammenfügen dieser beiden Filmträger wird erreicht, daß dieser Folienverbund nun sowohl beidseitig belichtet, als auch vollständig in den entsprechenden Lösungen eintauchen kann. Ein weiterer Vorteil liegt darin, daß beim beidseitigen Belichten unterschiedliche Strukturen auf der Ober- und Unterseite erzeugt werden können. Die weiteren Bearbeitungsprozesse sind unabhängig von der Struktur, wenn sichergestellt ist, daß beide Filme im gleichen Außenformat vorliegen.

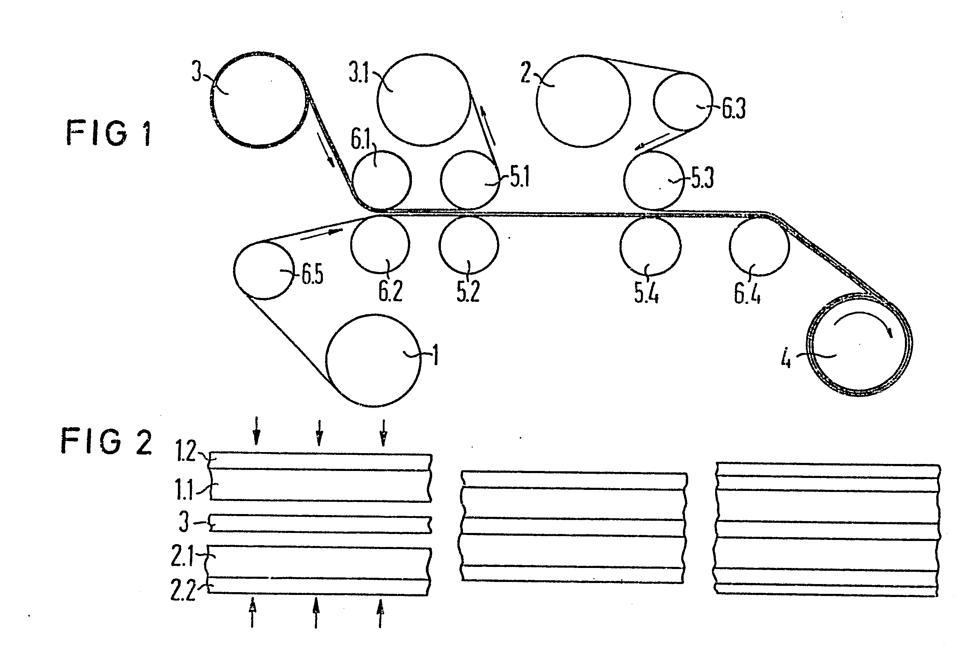

Anhand der Figuren 1 und 2 wird die Erfindung näher erläutert. Es zeigen:

Fig. 1 eine schematische Vorrichtung zum Zusammenfügen
der beiden Filme,

Fig. 2 einen Querschnitt der Filmlaminate im fortschreitenden Arbeitsprozess.

Das Zusammenfügen der beiden Filmträger wird anhand der
schematischen Anordnung nach Fig. 1 näher erläutert.

Von der Filmrolle 1 wird der Film 1 über die Führungswalzen
6 . 5, 6 . 1 und 6 . 4 sowie die Anpreßwalzen 5 . 1, 5 . 2, 5 . 3
und 5.4 zur Rolle 4 geführt. Gleichzeitig gelangt ein
zweiter Film über die Filmrolle 2 über die Führungwalzen
6 . 3 und 6 . 4 sowie die Anpreßwalzen 5 . 3 und 5 . 4 ebenfalls auf die Rolle 4. Das Verbindermaterial wird von der
Rolle 3 abgespult und über die Führungswalzen 6 . 1, 6 . 2
und 6 . 4 zwischen die beiden Filme eingeführt und ebenfalls der Walze 4, auf der das Laminat aufgewickelt wird,
zugeführt. Die am Verbindermaterial befindliche Schutzfolie wird nach den Anpreßwalzen 5 . 1 und 5.2 einer eigenen
Rolle 3 . 1 zugeführt, so daß sie automatisch vom Verbindermaterial abgezogen und auf der Rolle 3 . 1 aufgewickelt
wird.

Aus der Zeichnung der Fig. 2 sind die einzelnen Schichten
deutlich erkennbar. Die beiden Kunstoffträger 1 . 1 und
2 . 1 weisen auf ihren Außenseiten Metallschichten wie
z. B. Kupfer 1 . 2 und 2 . 2 auf. Zwischen den Rückseiten
der beiden Filme 1 . 1 und 2 . 1 liegt die Verbinderfolie 3.
Durch den Walzendruck werden die beiden Filme und die
Verbinderfolie zusammengedrückt, so daß ein Filmband
entsteht, wie es in der darauffolgenden Abbildung der
Fig. 2 gezeigt ist. Dabei sind beide Filme über
die Verbinderfolie miteinander verklebt. Zum Schluß wird
auf beide Kupferfolien noch Fotolack aufgebracht, so
daß dann, wie im dritten Bild der Fig. 2 gezeigt, das
verarbeitungsfähige Zwischenlaminat entsteht.

2 Figuren

1 Patentanspruch

Patentansprüche

1. Verfahren zur Herstellung von Halbleiterchips-Filmträgern, die aus einem auf der einen Seite mit einer eine
Fotolackschicht tragenden Kupferkaschierung versehenen
Kunststoffträger bestehen, bei dem auf der von der Kupferkaschierung abgewandten Seite im Bereich des jeweiligen
Halbleitereinbauplatzes eine Aussparung bis zur Kupferschicht vorgesehen ist und bei dem die Leiterstruktur
durch ein Fotoätzverfahren erzeugt ist, d a d u r c h
g e k e n n z e i c h n e t, daß zwei Filmträger kunststoffolienseitig über eine klebende Zwischenlage (3)
deckungsgleich vor dem Bearbeitungsprozess zusammengeklebt und nach dem Bearbeitungsprozess während des
Entschichtungsvorgangs wieder getrennt werden.

FIG 1

FIG 2

2  3  3.1  5.1  5.2  5.3  5.4  6.1  6.2  6.3  6.4  6.5  1  4

1.2  1.1  3  2.1  2.2